# EUROPÄISCHE PATENTSCHRIFT

(11) **EP 3 698 419 B1**
(45) Veröffentlichungstag und Bekanntmachung des Hinweises auf die Patenterteilung: **28.09.2022**
(21) Anmeldenummer: 18792390.9
(22) Anmeldetag: 18.10.2018
(51) Int. Cl.: H01M 10/42, H02J 7/00, G01R 31/36, H01M 50/572, B60L 58/21, G01R 31/00, G01R 31/3835, H01M 10/48, G01R 19/165, H02H 3/04, H02H 3/087

(54) **HOCHSPANNUNGS-BATTERIESYSTEM UND VERFAHREN ZUM BETREIBEN EINES HOCHSPANNUNG- BATTERIESYSTEMS**
HIGH-VOLTAGE BATTERY SYSTEM AND METHOD FOR OPERATING A HIGH-VOLTAGE BATTERY SYSTEM
SYSTÈME DE BATTERIE HAUTE TENSION ET PROCÉDÉ DE FONCTIONNEMENT D'UN SYSTÈME DE BATTERIE HAUTE TENSION

(30) Priorität: 19.10.2017 DE 102017218734
(43) Veröffentlichungstag der Anmeldung: 26.08.2020
(73) Patentinhaber: Volkswagen Aktiengesellschaft, 38440 Wolfsburg (DE)
(72) Erfinder: BRUNA, Michal, 38116 Braunschweig (DE); JUHL, Jochen, 31702 Lüdersfeld (DE); FRICKE, Benjamin, 38530 Didderse (DE)
(86) Internationale Anmeldenummer: PCT/EP2018/078533
(87) Internationale Veröffentlichungsnummer: WO 2019/077033

(56) Entgegenhaltungen:
- EP-A1- 1 107 344
- EP-A1- 1 107 344
- DE-A1-102012 018 321
- DE-A1-102012 018 321
- DE-A1-102012 214 953

## Beschreibung

Die vorliegende Erfindung betrifft ein Hochspannungs-Batteriesystem, insbesondere in einem Fahrzeug, mit einem Batteriemodul und zumindest zwei Schaltelementen, wobei durch die Schaltelemente eine elektrische Verbindung des Batteriemoduls mit einem Spannungsnetz schaltbar ist. Durch eine erste Erfassungseinheit ist ein erster Zellspannungsmesswert einer Zellspannung des Batteriemoduls erfassbar und durch eine erste Auswertungseinheit ist anhand eines Vergleichs des ersten Zellspannungsmesswerts mit einem ersten Schwellenwert ein erstes Steuersignal erzeugbar. Dabei ist anhand des ersten Steuersignals ein Schaltsignal erzeugbar. Die Erfindung betrifft ferner ein Verfahren zum Betreiben eines Hochspannungs-Batteriesystems, insbesondere in einem Fahrzeug. Bei dem Verfahren wird durch eine erste Erfassungseinheit ein Zellspannungsmesswert erfasst und durch eine erste Auswertungseinheit wird anhand eines Vergleichs des ersten Zellspannungsmesswerts mit einem ersten Schwellenwert ein erstes Steuersignal erzeugt. Dabei wird anhand des ersten Steuersignals ein Schaltsignal erzeugt.

Die zunehmende Verbreitung elektrisch betriebener Fahrzeuge sowie von Hybridfahrzeugen führt zu höheren Anforderungen an die Sicherheit beim Betrieb der hierzu benötigten Hochspannungsnetze im Fahrzeug. Insbesondere muss sichergestellt werden, dass die Batterien, die zur Speicherung elektrischer Energie eingesetzt werden, keinen zu hohen oder zu niedrigen Spannungen beziehungsweise Strömen ausgesetzt werden. Dies ist insbesondere zu beachten, wenn die Batterie durch einen Generator aufgeladen wird, der mechanische Energie des Antriebsstrangs in elektrische Energie umwandelt, oder wenn die Batterie über ein Stromnetz aufgeladen wird.

Um hohe Sicherheit zu gewährleisten, sind Vorgaben zu beachten, beispielsweise Normen für abgestufte Sicherheitsniveaus. Insbesondere wird im Automobilbereich die Klassifikation gemäß ASIL (*Automotive Safety Integrity Level*) verwendet, wobei beispielsweise die Anforderungen der Stufe ASIL-D erfüllt werden sollen.

Bei dem in der DE 10 2012 222 720 A1 beschriebenen Batteriemanagementsystem ist vorgesehen, dass durch zwei Zellüberwachungseinrichtungen einer Regelschaltung Betriebsparameter einer Batterie erfasst werden. Stellt eine erste Steuereinrichtung anhand eines erfassten Betriebsparameters einen kritischen Zellzustand fest, so sendet sie ein Signal an eine zweite Steuereinrichtung. Diese wertet redundant erfasste Betriebsparameter aus und steuert, wenn hier ein kritischer Zellzustand festgestellt wird, ein Schaltelement an.

Die DE 10 2011 004 980 A1 schlägt eine redundante Zellspannungserfassung vor, bei der ein Zellspannungserfassungsbaustein Zellspannungen von Batteriezellen erfasst und ferner durch eine erste Messelektronik eine analoge Messgröße ausgegeben wird, die proportional zu einer extremen Zellspannung ist.

Weiterer relevanter Stand der Technik ist in den Dokumenten: DE 10 2012 214953 A1, EP 1 107 344 A1 und DE 10 2012 018321 A1 beschrieben.

Der vorliegenden Erfindung liegt die Aufgabe zugrunde, einen zuverlässigen Schutz eines Batteriemoduls vor schädlichen Strom- beziehungsweise Spannungswerten zu gewährleisten. Ferner sollen die Komponenten des Systems mit einer möglichst langen Lebensdauer betrieben werden, um notwendige Reparaturen und Wartungsarbeiten zu begrenzen.

Erfindungsgemäß wird diese Aufgabe durch ein Hochspannungs-Batteriesystem mit den Merkmalen des Anspruchs 1 und ein Verfahren zum Betreiben eines Hochspannungs-Batteriesystems mit den Merkmalen des Anspruchs 7 gelöst. Vorteilhafte Ausgestaltungen und Weiterbildungen ergeben sich aus den abhängigen Ansprüchen.

Das erfindungsgemäße System der eingangs genannten Art ist dadurch gekennzeichnet, dass das Schaltsignal an zumindest eine erste Ansteuerungseinheit für das erste Schaltelement und an eine zweite Ansteuerungseinheit für das zweite Schaltelement übertragbar ist, wobei in Abhängigkeit von dem Schaltsignal das erste und das zweite Schaltelement unabhängig voneinander schaltbar sind.

Dadurch kann vorteilhafterweise gezielt ein bestimmtes Schaltelement zum Schalten verwendet werden oder das Schalten kann mittels beider Schaltelemente vorgenommen werden. Wenn die Schaltelemente eine begrenzte Lebensdauer aufweisen, insbesondere wenn mit ihnen lediglich eine bestimmte Anzahl von Schaltvorgängen unter Last durchgeführt werden kann, erlaubt das erfindungsgemäße Hochspannungs-Batteriesystem eine besonders effiziente Nutzung unter Vermeidung unnötiger Reparaturen und Wartungsarbeiten.

Ferner wird eine redundante Schaltung bereitgestellt, um insbesondere sicherheitsrelevante Schaltvorgänge besonders zuverlässig auszuführen. Durch die Redundanz kann eine Kombination von Systemkomponenten verwendet werden, die alleine nicht zum Erfüllen besonders hoher Anforderungen an die Ausfallsicherheit geeignet wären. Insbesondere kann durch diese Dekomposition, das heißt durch einander gegenseitig absichernde Komponenten, eine besonders geringe Wahrscheinlichkeit von Fehlern des Systems erreicht werden. Ferner können dadurch Kosten gesenkt werden.

Das Batteriemodul ist auf an sich bekannte Weise gebildet und umfasst insbesondere mehrere einzelne Zellen beziehungsweise Batterien. Das Batteriemodul kann auch aus mehreren Batteriemodulen zusammengesetzt sein. Das Batteriemodul kann elektrische Energie aufnehmen und speichern beziehungsweise abgeben. Die elektrische Verbindung mit dem Spannungsnetz ist ebenfalls auf an sich bekannte Weise so ausgebildet, dass dem Batteriemodul über das Spannungsnetz elektrische Energie zugeführt oder entnommen werden kann.

Gemäß einer Ausgestaltung des erfindungsgemäßen Systems ist das Batteriemodul durch das Spannungsnetz mit einem Traktionsnetz des Fahrzeugs elektrisch verbunden. Dadurch kann das Hochspannungs-Batteriesystem vorteilhafterweise verwendet werden, um die elektrische Verbindung des Batteriemoduls mit Hochvoltkomponenten des Fahrzeugs zu steuern. Die dabei auftretenden Spannungen liegen insbesondere in einem Bereich von mehr als 60 V.

Insbesondere wird das System in einem elektrischen oder Hybridfahrzeug eingesetzt, bei dem die Einrichtungen zum Antrieb des Fahrzeugs einen wesentlichen Teil der gesamten Energie aufnehmen, die von dem Batteriemodul bereitgestellt wird. Umgekehrt kann aus dem Traktionsnetz Energie zum Aufladen der Batterie bereitgestellt werden. In beiden Fällen gilt es, eine Belastung des Batteriemoduls durch zu niedrige und insbesondere zu hohe Spannungen beziehungsweise Ströme zu vermeiden.

Bei einer Ausbildung umfassen die Schaltelemente zumindest zwei Schütze. Diese Schaltelemente erlauben vorteilhafterweise eine sichere Schaltung bei großen elektrischen Leistungen.

Alternativ oder zusätzlich können andere Arten von Schaltelementen verwendet werden, insbesondere Relais oder Halbleiterschalter für Hochspannung. Ferner können pyrotechnische Sicherungen verwendet werden. Die Schütze beziehungsweise andere Schaltelemente sind auf an sich bekannte Weise gebildet.

Die Schaltelemente weisen zumindest zwei Zustände auf, nämlich einen geöffneten und einen geschlossenen Zustand. Je nach dem Zustand der Schaltelemente kann die elektrische Verbindung des Batteriemoduls mit dem Spannungsnetz geöffnet oder geschlossen sein. Es kann ein Schaltvorgang durchgeführt werden, um von einem Zustand zu einem anderen zu gelangen. Bei einem solchen Schaltvorgang kann die elektrische Verbindung zumindest geöffnet werden, um das Batteriemodul elektrisch von dem Spannungsnetz zu trennen, wobei insbesondere das Öffnen eines der Schaltelemente ausreicht, um das Spannungsnetz beziehungsweise das Traktionsnetz von dem Batteriemodul zu trennen. Ferner kann bei dem Schaltvorgang die elektrische Verbindung geschlossen werden, wobei der Stromkreis insbesondere dann geschlossen ist, wenn sich beide Schaltelemente in dem geschlossenen Zustand befinden.

Das erste und das zweite Schaltelement sind dabei insbesondere an unterschiedlichen Polen des Batteriemoduls angeordnet, wobei jedoch auch weitere Anordnungen der Schaltelemente in dem Stromkreis möglich sind.

Bei dem Hochspannungs-Batteriesystem gemäß der Erfindung erfolgt auf an sich bekannte Weise eine Erfassung der Zellspannung des Batteriemoduls. Dabei werden insbesondere die Zellspannungen sämtlicher Zellen des Batteriemoduls gemessen. Der dabei ermittelte Zellspannungsmesswert wird mit einem ersten Schwellenwert verglichen. Der Zellspannungsmesswert wird dazu an die erste Auswertungseinheit übertragen, wobei zu diesem Zweck ein analoges oder digitales Signal verwendet werden kann. Insbesondere ist hierzu eine erste Schnittstelle zur Übertragung der Zellspannung vorgesehen, die beispielsweise mittels CAN (*Controller Area Network*)*,* ISO-SPI (*Serial Peripheral Interface*), TPL (*Transceiver Physical Layer*) oder einer ähnlichen Technologie gebildet ist.

Der erste Schwellenwert kann auf unterschiedliche Weise bereitgestellt werden, etwa als voreingestellter oder dynamisch bestimmbarer Grenzwert. Er gibt insbesondere an, oberhalb beziehungsweise unterhalb welcher gemessenen Spannung das Batteriemodul von dem Spannungsnetz getrennt werden soll. Der Schwellenwert kann sich beispielsweise je nach Eigenschaften des Batteriemoduls oder weiterer Einrichtungen, die mit dem Spannungsnetz verbunden sind, unterscheiden. Insbesondere können mehrere Schwellenwerte vorgesehen sein, etwa um zu bestimmen, ob und in welchem Maße ein erfasster Zellspannungsmesswert von einem Sollwert abweicht und um unterschiedliche Reaktionen auf diese Abweichung auszulösen. Beispielsweise kann bei einer geringeren Abweichung eine Warnung ausgegeben werden und/oder andere mit dem Spannungsnetz verbundene Einrichtungen können so eingestellt werden, dass die Abweichung vermieden wird. Bei größeren Abweichungen kann eine Trennung des Batteriemoduls von dem Spannungsnetz vorgenommen werden, wobei die Art der Trennung ebenfalls von der Größe der Abweichung abhängen kann.

Das anhand des Vergleichs des ersten Zellspannungsmesswert mit dem ersten Schwellenwert erzeugte erste Steuersignal dient insbesondere zur Einleitung einer Reaktion auf eine Abweichung des Zellspannungsmesswert von einem Sollwert beziehungsweise einem vorgegebenen Bereich, in dem sich der Zellspannungsmesswert befinden soll. Insbesondere dient das Steuersignal dazu, in einem weiteren Schritt das Schaltsignal für die erste beziehungsweise zweite Ansteuereinheit zum Ansteuern der Schaltelemente zu erzeugen. Das erste Steuersignal kann dabei insbesondere zumindest zwei Teilsignale umfassen, die jeweils zur Erzeugung des Schaltsignals für das erste beziehungsweise zweite Schaltelement dienen.

Durch das erste Steuersignal wird insbesondere bestimmt, mit welchem der Schaltelemente ein Schaltvorgang durchgeführt werden soll beziehungsweise welche Art von Schaltvorgang durchgeführt werden soll. Dies wird bei der Erzeugung des Schaltsignals so umgesetzt, dass die erste und zweite Ansteuerungseinheit für das erste beziehungsweise zweite Schaltelement diese gewünschten Schaltvorgänge auslösen.

Auch das Schaltsignal kann zwei Teilsignale umfassen, in Abhängigkeit von denen das erste beziehungsweise zweite Schaltelement abschaltbar ist. Insbesondere können einzelne Teilsignale des Schaltsignals an die erste beziehungsweise zweite Ansteuerungseinheit übertragen werden, sodass nicht notwendigerweise das gesamte Schaltsignal an beide Ansteuerungseinheiten übertragen wird.

Bei einer weiteren Ausbildung ist durch eine zweite Erfassungseinheit ein zweiter Zellspannungsmesswert einer Zellspannung des Batteriemoduls erfassbar und durch eine zweite Auswertungseinheit ist anhand eines Vergleichs des zweiten Zellspannungsmesswerts mit einem zweiten Schwellenwert ein Alarmsignal erzeugbar. Dadurch kann vorteilhafterweise eine besonders sichere Reaktion auf eine Abweichung der Zellspannung von einem Sollbereich eingeleitet werden. Ferner wird vorteilhafterweise eine Redundanz eingeführt, die zusätzlich zur ersten Erfassungseinheit eine Überwachung der Zellspannung erlaubt.

Die zweite Erfassungseinheit und die zweite Auswertungseinheit sind direkt mit dem Batteriemodul integriert, beispielsweise durch ihre Integration in ein Zellmodul-Steuergerät (CMC, *Cell Module Controller).* Dadurch sind eine besonders kompakte Bauweise und eine bauliche Trennung unterschiedlicher Komponenten des Systems möglich.

Der zweite Schwellenwert wird auf ähnliche Weise wie der erste Schwellenwert gebildet und wird voreingestellt oder ist dynamisch bestimmbar . Der zweite Schwellenwert kann etwa gleich dem ersten Schwellenwert sein. Insbesondere ist beim Überbeziehungsweise Unterschreiten des zweiten Schwellenwerts eine Trennung des Batteriemoduls von dem Spannungsnetz vorgesehen. Auch der zweite Schwellenwert kann dabei beispielsweise von Eigenschaften des Batteriemoduls oder weiterer Einrichtungen abhängen, die mit dem Spannungsnetz verbunden sind. Mehrere unterschiedliche Schwellenwerte können ferner dazu dienen, bei Abweichungen des erfassten Zellspannungsmesswerts von einem Sollwert unterschiedliche Vorgänge und beispielsweise eine gestufte Reaktion auszulösen, etwa die Ausgabe einer Warnung, bestimmte Einstellungen andere Einrichtungen des Spannungsnetzes oder eine Trennung des Batteriemoduls von dem Spannungsnetz.

Das Alarmsignal wird auf an sich bekannte Weise erzeugt, insbesondere als digitales Signal, etwa unter Verwendung unterschiedlicher Strom-oder Spannungspegel (*highllow*, *low*/*high*), insbesondere mit einem periodischen Signal ("*heartbeat*"), durch das die Funktionsfähigkeit der zweiten Erfassungseinheit überwacht werden kann.

In einer weiteren Ausbildung der Erfindung kann eine Übertragung der Signale ausschließlich über ein Bussystem erfolgen. Insbesondere erfolgt in diesem Fall eine besonders abgesicherte Übertragung der Zellspannungsmesswerte, wodurch eine besonders sichere Übertragung der Signale ermöglicht wird. Das Alarmsignal kann in diesem Fall erst nach der Übertragung der Zellspannungsmesswerte erzeugt werden, beispielsweise innerhalb der Auswertungseinheit. Zur Erhöhung der Sicherheit kann vorgesehen sein, dass die Verarbeitung anhand zweier unterschiedlicher Rechnerkerne (Cores) erfolgt, sodass das Alarmsignal durch einen redundanten, von der weiteren Verarbeitung des Zellspannungsmesswerts unabhängigen Verarbeitungsweg erzeugt wird.

Bei einer Weiterbildung sind das erste Steuersignal und das Alarmsignal an eine Logikeinheit übertragbar und das Schaltsignal ist durch die Logikeinheit erzeugbar. Die Logikeinheit kann die unterschiedlichen Signale vorteilhafterweise durch unterschiedliche Verfahren verknüpfen, um sie bei der Erzeugung des Schaltsignals zu berücksichtigen. Insbesondere können dadurch redundante Daten der ersten Auswertungseinheit und der zweiten Auswertungseinheit bewertet und verknüpft werden.

Die Verarbeitung des ersten Steuersignals und des Signals durch die Logikeinheit kann dabei auf an sich bekannte Weise erfolgen, beispielsweise mittels einer UND- oder ODER-Verknüpfung. Alternativ oder zusätzlich können weitere Verarbeitungsschritte vorgesehen sein, um anhand der eingehenden Signale das Schaltsignal zu erzeugen.

Gemäß der Erfindung wird durch eine Sicherungs-Steuereinheit ein Auslösungssignal für ein Sicherungselement erzeugt, wobei das Sicherungselement in Abhängigkeit von dem Auslösungssignal auslösbar ist. Dadurch kann das Sicherungselement als redundante Einrichtung zur Trennung des Batteriemoduls von dem Spannungsnetz verwendet und durch das Alarmsignal unabhängig von einem Steuersignal der ersten Auswertungseinheit betrieben werden.

Das Sicherungselement kann beispielsweise eine Pyrosicherung oder eine Schmelzsicherung umfassen. Alternativ oder zusätzlich kann eine weitere Einheit umfasst sein, die eine besonders sichere Trennung des Spannungsnetzes beziehungsweise des Traktionsnetzes von dem Batteriemodul ermöglicht, insbesondere beim Betrieb des Systems mit hoher Spannung beziehungsweise hohem Stromfluss. Beim Auslösen einer pyrotechnischen Sicherung erfolgt eine Trennung von elektrisch verbundenen Elementen mittels Sprengkraft. Diese Trennung ist nicht reversibel, sodass die elektrische Verbindung erst durch eine Reparatur des Systems wiederhergestellt werden kann. Diese Trennung ist besonders zuverlässig wirksam, insbesondere auch bei Vorliegen eines hohen Stroms oder einer hohen Spannung, wobei die Trennung durch einen anderen Schalter, etwa durch Bildung eines Lichtbogens, erschwert wird. Dabei kann das Alarmsignal durch die Sicherungs-Steuereinheit auf verschiedene Weise verarbeitet werden, um das Auslösungssignal zu erzeugen. Beispielsweise kann eine Bewertung des Alarmsignals vorgenommen werden, um Fehlfunktionen auszuschließen.

Gemäß der Erfindung wird durch eine Stromerfassungseinheit ein Strommesswert eines elektrischen Stroms zu dem Batteriemodul erfasst und das Auslösungssignal für das Sicherungselement wird ferner in Abhängigkeit von dem erfassten Strommesswert erzeugt. Die Auslösung des Sicherungselements wird daher von mehreren Messwerten abhängig gemacht, nämlich einer Messung der Zellspannung und einer Messung des elektrischen Stroms. Dadurch wird eine weitere Redundanz erreicht.

Die Strommessung kann auf an sich bekannte Weise erfolgen, beispielsweise anhand des Spannungsabfalls über einen Shunt. Der erfasste Strommesswert kann dabei in unterschiedliche Genauigkeit Informationen über die Größe des gemessenen Stroms umfassen. Er kann ferner eine qualitative Aussage über die Stromstärke umfassen, etwa ob ein bestimmter Stromschwellenwert überschritten wird.

Der Strommesswert kann bei der Erzeugung des Auslösungssignals insbesondere über eine logische Operation mit dem Alarmsignal verknüpft werden, etwa mittels einer UND- oder einer ODER-Verknüpfung. Das Sicherungselement kann dann insbesondere ausgelöst werden, wenn anhand beider Signale die Notwendigkeit einer solchen Maßnahme, erkannt wird.

Es kann auch vorgesehen sein, dass das Sicherungselement allein in Abhängigkeit von dem Strommesswert auslösbar ist, ohne dass dabei das Alarmsignal berücksichtigt wird. Dies kann insbesondere dazu dienen, das System unabhängig von der Überwachung der Zellspannung gegen einen zu hohen Stromfluss zu schützen. Ein derart angesteuertes Sicherungselement kann bei dem erfindungsgemäßen Hochspannungs-Batteriesystem in verschiedenen Ausführungsformen ergänzend vorgesehen sein.

Gemäß einer Weiterbildung ist das Alarmsignal an eine Zwischen-Auswertungseinheit übertragbar und durch die Zwischen-Auswertungseinheit ist anhand des Alarmsignals ein zweites Steuersignal erzeugbar. Dabei ist das Schaltsignal ferner anhand des zweiten Steuersignals erzeugbar. Somit können vorteilhafterweise weitere Operationen auf das Alarmsignal angewandt werden und das Schaltsignal kann besonders flexibel und an die jeweilige Situation angepasst erzeugt werden.

Die Zwischen-Auswertungseinheit kann beispielsweise als eigene Baugruppe, etwa als sekundärer Mikrocontroller, ausgeführt sein und das zweite Steuersignal kann insbesondere gemeinsam mit dem ersten Steuersignal zur Erzeugung des Schaltsignals verwendet werden. Durch die Zwischen-Auswertungseinheit können beispielsweise Anweisungen einer Software ausgeführt werden, durch die das zweite Steuersignal anhand des Alarmsignals und in Abhängigkeit von weiteren Bedingungen erzeugt werden kann. Es ist dabei möglich, durch eine Software in die Übertragung des Alarmsignals einzugreifen und/oder das Alarmsignal zu modifizieren.

Bei einer Ausbildung wird durch die Zwischen-Auswertungseinheit eine Bewertung des Alarmsignals erzeugt und das zweite Steuersignal wird anhand der Bewertung erzeugt. Diese Bewertung kann eine Verarbeitung des Alarmsignals auf unterschiedliche Weisen umfassen. Dadurch kann das zweite Steuersignal zur Erzeugung des Schaltsignals vorteilhafterweise so gebildet werden, dass das Alarmsignal beim Schalten der Schaltelemente berücksichtigt wird, insbesondere in Verbindung mit weiteren Bedingungen.

Beispielsweise kann eine Entprellung des Alarmsignals vorgenommen werden, etwa indem ein Zeitintervall definiert wird, für dessen Dauer ein bestimmtes Alarmsignal detektiert werden muss, bevor das zweite Steuersignal erzeugt beziehungsweise ein Schaltvorgang und/oder eine andere Reaktion auf das Alarmsignal ausgelöst wird. Alternativ oder zusätzlich kann ein zeitlicher Versatz erzeugt werden, wobei das zweite Steuersignal eine bestimmte Zeitspanne nach dem Alarmsignal erzeugbar ist, etwa um eine unerwünschte, zu schnelle Reaktion auf das Alarmsignal zu vermeiden und beispielsweise eine schonendere Abschaltung von mit dem Spannungsnetz verbundenen Einheiten vornehmen zu können. Ferner kann die Art des ausgelösten Schaltvorgangs beziehungsweise der Reaktion auf das Alarmsignal anhand der Bewertung des Alarmsignals bestimmt werden.

Dadurch können beispielsweise Fehlfunktionen vermieden werden. Zudem können weitere Parameter berücksichtigt werden, etwa bei Spannungs- und/oder Strommessungen erfassten Messwerte. Die Zwischen-Auswertungseinheit kann ferner verwendet werden, um mittels Software Einfluss auf das Alarmsignal zu nehmen und dieses zu kontrollieren und beispielsweise bei Fehlfunktionen durch ein anderes Signal zu überschreiben.

Alternativ oder zusätzlich kann die Bewertung durch die zweite Auswertungseinheit erzeugt und somit bereits bei der Erzeugung des Alarmsignals berücksichtigt werden, wobei insbesondere keine Zwischen-Auswertungseinheit vorgesehen ist.

Bei dem erfindungsgemäßen Verfahren zum Betreiben eines Hochspannungs-Batteriesystems der eingangs genannten Art wird das Schaltsignal an zumindest eine erste Ansteuerungseinheit für ein erstes Schaltelement und an eine zweite Ansteuerungseinheit für ein zweites Schaltelement übertragen, wobei durch die Schaltelemente eine elektrische Verbindung des Batteriemoduls mit einem Spannungsnetz schaltbar ist und in Abhängigkeit von dem Schaltsignal das erste und das zweite Schaltelement unabhängig voneinander geschaltet werden.

Das erfindungsgemäße Verfahren ist insbesondere ausgebildet, das vorstehend beschriebene Hochspannungs-Batteriesystem zu betreiben. Das Verfahren weist somit dieselben Vorteile auf wie das erfindungsgemäße System.

Insbesondere wird bei dem Verfahren der erste Zellspannungsmesswert mittels eines analogen Signals an die erste Auswertungseinheit übertragen, wobei diese insbesondere als Haupt-Mikrocontroller ausgebildet sein kann.

Das Schaltsignal umfasst eine Information darüber, welches der beiden Schaltelemente oder ob beide Schaltelemente geschaltet werden sollen. Es kann vorgesehen sein, dass unterschiedliche Schaltvorgänge durch die Schaltelemente ausgeführt werden können, wobei in diesem Fall das Schaltsignal ebenfalls eine Information umfasst, welche Art von Schaltvorgang, gegebenenfalls durch welches der Schaltelemente, durchgeführt werden soll.

Die Erfindung wird nun anhand von Ausführungsbeispielen mit Bezug zu den Zeichnungen erläutert.
- Figur 1: zeigt ein erstes Ausführungsbeispiel des erfindungsgemäßen Hochspannungs-Batteriesystems,
- Figur 2: zeigt ein zweites Ausführungsbeispiel des erfindungsgemäßen Hochspannungs-Batteriesystems und
- Figur 3: zeigt ein drittes Ausführungsbeispiel des erfindungsgemäßen Hochspannungs-Batteriesystems.

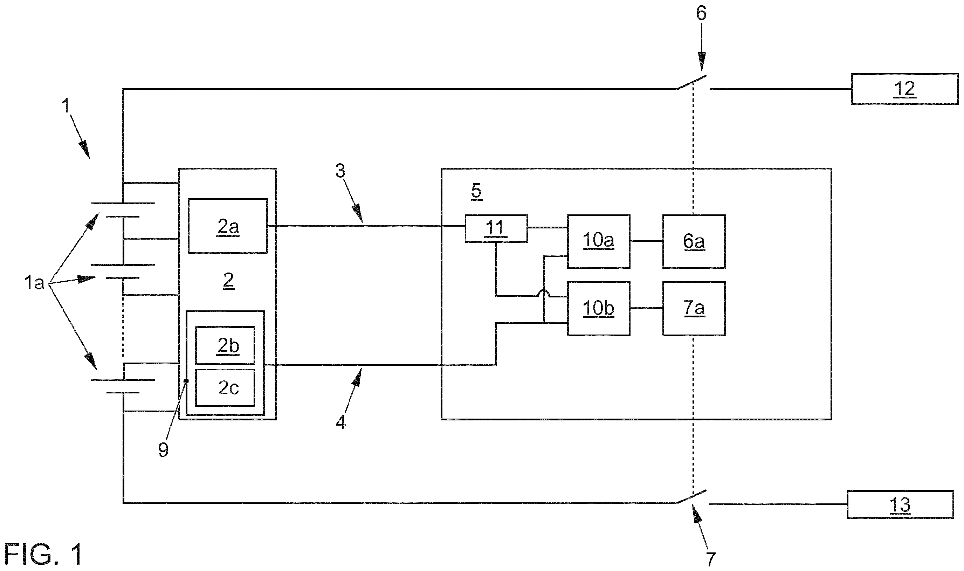

Mit Bezug zu Figur 1 wird ein erstes Ausführungsbeispiel des erfindungsgemäßen Hochspannungs-Batteriesystems erläutert.

Das Hochspannungs-Batteriesystem umfasst ein Batteriemodul 1 mit Batterien 1a. Mit dem Batteriemodul ist ein Batteriemodul-Controller (CMC) 2 gekoppelt, der wiederum eine erste Erfassungseinheit 2a sowie ein Alarmmodul 9 mit einer zweiten Erfassungseinheit 2 b und einer zweiten Auswertungseinheit 2c umfasst. Das System umfasst ferner einen Batteriemanagement-Controller (BMC) 5 mit einer ersten Erfassungseinheit 11, in diesem Fall ausgebildet als Haupt-Mikrocontroller 11, sowie Logikeinheiten 10a, 10b und Ansteuerungseinheiten 6a, 7a.

Durch eine Kommunikationsleitung 3 ist der Batteriemodul-Controller 2 mit der ersten Auswertungseinheit 11, hier einem Haupt-Mikrocontroller 11 datentechnisch so verbunden, dass Daten von der ersten Erfassungseinheit 2a an den Haupt-Mikrocontroller 11 übertragbar sind. Die Kommunikationsleitung 3 kann dabei beispielsweise ein CAN-Bus sein oder ISO-SPI oder TPL für die Übertragung von Daten verwenden. Ferner ist der Batteriemodul-Controller 2 durch eine Alarmleitung 4 mit den Logikeinheiten 10a, 10b datentechnisch so verbunden, dass Signale von dem Alarmmodul 9 an die Logikeinheiten 10a, 10b übertragbar sind. Dadurch wird eine redundante Kommunikation zwischen dem Batteriemodul-Controller 2 und dem Batteriemanagement-Controller 5 implementiert.

Die Logikeinheiten 10a, 10b sind ferner mit dem Haupt-Mikrocontroller 11 gekoppelt. Ferner ist eine erste Logikeinheit 10a mit einer Ansteuerungseinheit 6a gekoppelt, die wiederum mit einem Schaltelement 6 gekoppelt ist. Analog dazu ist eine weitere Logikeinheit 10b mit einer weiteren Ansteuerungseinheit 7a gekoppelt, die wiederum mit einem Schaltelement 7 gekoppelt ist. Die Schaltelemente 6, 7 sind bei dem Ausführungsbeispiel als Schütze 6, 7 ausgebildet. Durch die Schaltelemente 6, 7 kann eine elektrische Verbindung des Batteriemoduls 1 mit einem Spannungsnetz geschaltet werden, wobei das Batteriemodul 1 durch das Spannungsnetz mit einem positiven 12 und einem negativen Anschluss 13 eines Traktionsnetzes eines Fahrzeugs verbindbar ist.

Ausgehend von dem oben mit Bezug zu Figur 1 erläuterten Ausführungsbeispiel des erfindungsgemäßen Hochspannungs-Batteriesystems wird ein Ausführungsbeispiel des erfindungsgemäßen Verfahrens erläutert.

Bei dem Verfahren werden Zellspannungen der Batterien 1a beziehungsweise eine Zellspannung des Batteriemoduls 1 durch die erste Erfassungseinheit 2a des CMC 2 erfasst und über die Kommunikationsleitung 3 an den BMC 5 mit dem Haupt-Mikrocontroller 11 übertragen. Die Datenübertragung erfolgt bei dem Ausführungsbeispiel mittels digitaler Signale, das heißt digitalisierter Analogwerte der Zellspannung. In weiteren Ausführungsbeispielen kann eine analoge Datenübertragung vorgesehen sein. Der Haupt-Mikrocontroller vergleicht den Wert der erfassten Zellspannung mit einem ersten Schwellenwert, der bei dem Ausführungsbeispiel fest vorgegeben ist. Bei weiteren Ausführungsbeispielen kann der erste Schwellenwert dynamisch bestimmt werden, beispielsweise anhand von Parametern des Batteriemoduls 1 oder weiterer mit dem Traktionsnetz verbundener Einheiten.

Bei dem Vergleich wird bestimmt, ob der Wert der erfassten Zellspannung den vorgegebenen Grenz- beziehungsweise Schwellenwert über- oder unterschreitet. Es können mehrere Grenzwerte vorgesehen sein, insbesondere für Zellspannungen unterschiedlicher Zellen des Batteriemoduls 1 oder um bestimmte Arten von Unter- oder Überspannungen zu charakterisieren. Wenn eine solche Abweichung festgestellt wird, ist bei dem Ausführungsbeispiel vorgesehen, dass zumindest eines der Schaltelemente 6, 7 so angesteuert wird, dass das Batteriemodul von dem Spannungsnetz getrennt wird. Dazu wird insbesondere zumindest eines der Schaltelemente 6, 7 geöffnet, sodass der Stromfluss unterbrochen wird.

Zu diesem Zweck wird ein erstes Steuersignal erzeugt und bei dem Ausführungsbeispiel an die Logikeinheiten 10a, 10b übertragen. Dabei ist in dem Ausführungsbeispiel ferner vorgesehen, dass bei der Erzeugung des ersten Steuersignals bestimmt wird, ob beide Schaltelemente 6, 7 oder lediglich ein bestimmtes Schaltelement 6, 7 geschaltet werden soll. Das erste Steuersignal umfasst dann Informationen darüber, welcher Schaltvorgang für die einzelnen Schaltelemente 6, 7 durchgeführt werden soll.

Bei dem Ausführungsbeispiel kann insbesondere vorgesehen sein, dass durch einen Zähler erfasst wird, wie oft die einzelnen Schaltelemente 6, 7 bereits unter der Last einer Überspannung geschaltet wurden. Ist eine bestimmte Anzahl solcher Schaltvorgänge erreicht, wird ein Signal ausgegeben, welches den Ablauf der Lebensdauer der jeweiligen Schaltelemente 6, 7 anzeigt. Bei dem Ausführungsbeispiel können die Schaltelemente 6, 7 nicht nur gemeinsam, sondern auch einzeln geschaltet werden. Dies ermöglicht es, sie abwechselnd zu verwenden, sodass eine größere Anzahl von Schaltvorgängen vorgenommen werden kann, bevor die Schaltelemente 6, 7 ausgetauscht werden müssen.

Wenn beispielsweise die Schütze 6, 7 jeweils viermal unter einer Last von jeweils 400 A geschaltet werden können, sind bei jeweils gleichzeitiger Öffnung der Schütze 6, 7 vier Schaltvorgänge unter solchen Bedingungen möglich, während beim abwechselnden Öffnen bis zu acht Schaltvorgänge durchgeführt werden können.

Bei dem Ausführungsbeispiel ist vorgesehen, dass das erste Steuersignal zwei Teilsignale umfasst, die an eine erste Logikeinheit 10a beziehungsweise eine zweite Logikeinheit 10b übertragen werden. Diese Teilsignale können jeweils lediglich Informationen umfassen, welche die mit der jeweiligen Logikeinheit 10a, 10b gekoppelte Ansteuerungseinheit 6a, 7a beziehungsweise das zugeordnete Schaltelement 6, 7 betreffen.

Zusätzlich erfolgt eine Erfassung der Zellspannung mittels der zweiten Erfassungseinheit 2b des Alarmmoduls 9 des CMC 2. Der hierbei erfasste Wert wird durch die zweite Auswertungseinheit 2c mit einem Schwellenwert verglichen, der bei dem Ausführungsbeispiel mit dem durch den Haupt-Mikrocontroller verwendeten Schwellenwert identisch ist. Bei einer so erfassten Grenzwertverletzung der erfassten Zellspannung wird durch die zweite Auswertungseinheit 2c ein Alarmsignal erzeugt und über die Alarmleitung 4 an den BMC 5 übertragen.

In einem weiteren Ausführungsbeispiel ist vorgesehen, dass das Alarmsignal nicht durch eine zweite Auswertungseinheit 2c erzeugt wird, sondern dass die gesamte Verarbeitung durch den BMC 5 erfolgt, wobei insbesondere eine weitere im BMC 5 integrierte Recheneinheit vorgesehen ist (insbesondere ein separater Rechenkern des Haupt-Mikrocontroller). Dies setzt voraus, dass die verwendeten Komponenten besonders hohen Anforderungen entsprechen, insbesondere betreffend die Wahrscheinlichkeit von Fehlfunktionen.

Bei dem Ausführungsbeispiel ist das Alarmsignal digital ausgebildet und insbesondere durch einen Wechsel von einem höheren zu einem niedrigeren Pegel beziehungsweise umgekehrt von einem niedrigeren zu einem höheren Pegel charakterisiert. Alternativ oder zusätzlich kann ein periodisches Heartbeat-Signal verwendet werden, das die Funktionsfähigkeit des Alarmmoduls 9 signalisiert und zur Übertragung des Alarmsignals moduliert wird. Ferner kann eine analoge Übertragung des Alarmsignals vorgesehen sein.

Das an den BMC 5 übertragene Alarmsignal wird bei dem Ausführungsbeispiel von den Logikeinheiten 10a, 10b empfangen. Das heißt, die Logikeinheiten 10a, 10b empfangen das erste Steuersignal (beziehungsweise gegebenenfalls Teilsignale des ersten Steuersignals) und das Alarmsignal durch die Logikeinheiten 10a, 10b ist eine logische Operation durchführbar, etwa mittels eines UND-Operators oder eines ODER-Operators. Auf diese Weise kann beispielsweise die Betätigung eines Schaltelements 6, 7 daran geknüpft sein, dass sowohl das Steuersignal als auch das Alarmsignal einen bestimmten Zustand aufweisen, beispielsweise dass keines der beiden Signale eine Schwellenwertüberschreitung signalisiert. Alternativ kann die logische Verknüpfung so erfolgen, dass geprüft wird, ob zumindest eines der beiden Signale eine Schwellenwertüberschreitung signalisiert. In weiteren Ausführungsbeispielen können alternativ oder zusätzlich weitere Verarbeitungsschritte, insbesondere logische Operationen, vorgenommen werden.

Durch die Logikeinheiten 10a, 10b wird schließlich ein Schaltsignal erzeugt und an die Ansteuerungseinheiten 6a, 7a für die jeweiligen Schaltelemente 6, 7 übertragen. Das Schaltsignal umfasst bei dem Ausführungsbeispiel zwei Teilsignale für die beiden Schaltelemente 6, 7. Durch das Schaltsignal wird ein Schaltvorgang für eines der Schaltelemente 6, 7 oder beide Schaltelemente 6, 7 ausgelöst.

In weiteren Ausführungsbeispielen können mehr als zwei Schaltelemente 6, 7 vorgesehen sein und/oder die mittels der Schaltelemente 6, 7 durchführbaren Schaltvorgänge können weitere Möglichkeiten zusätzlich zum Öffnen oder Schließen der elektrischen Verbindung umfassen. Die Ansteuerung erfolgt analog zu dem oben erläuterten Ausführungsbeispiel.

Ferner kann lediglich eine Ansteuerungseinheit 6a, 7a vorgesehen sein, durch die beide Schaltelemente 6, 7 unabhängig voneinander ansteuerbar sind. Zudem kann eine einzelne Logikeinheit 10a, 10b vorgesehen sein oder das Schaltsignal kann direkt durch den Haupt-Mikrocontroller 11 erzeugt und an die Steuerungseinheit oder die Steuerungseinheiten 6a, 7a übertragen werden.

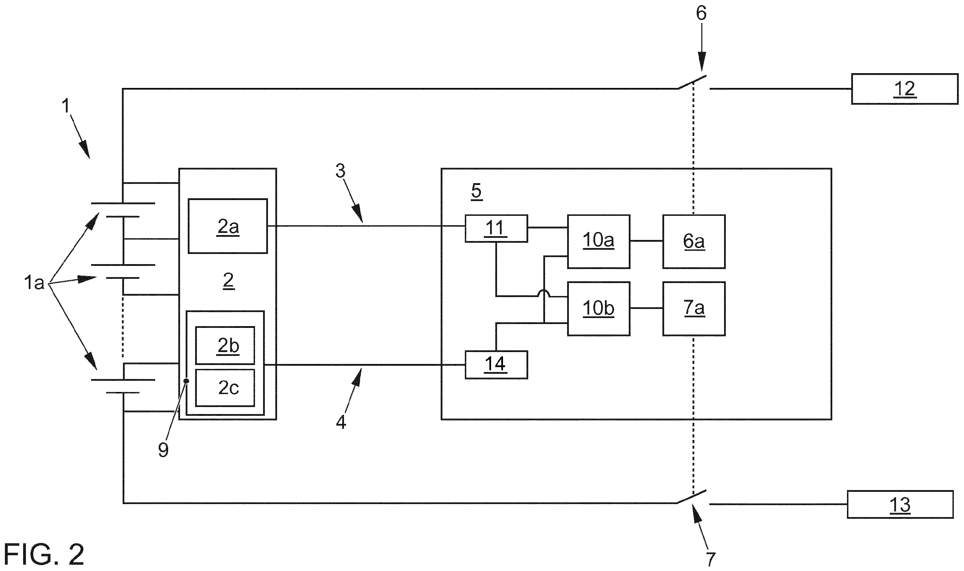

Mit Bezug zu Figur 2 wird ein zweites Ausführungsbeispiel des erfindungsgemäßen Hochspannungs-Batteriesystems erläutert.

Das zweite Ausführungsbeispiel basiert auf dem oben mit Bezug zu Figur 1 erläuterten ersten Ausführungsbeispiel. Analog ausgebildete Komponenten des Systems sind daher mit den gleichen Bezugszeichen versehen und werden nachfolgend nicht noch einmal ausführlich erläutert.

Bei dem zweiten Ausführungsbeispiel ist im Unterschied zu dem ersten Ausführungsbeispiel ein Sekundär-Mikrocontroller 14 als Zwischen-Auswertungseinheit 14 vorgesehen. Dieser ist über die Alarmleitung 4 mit dem CMC 2 und insbesondere dem Alarmmodul 9 gekoppelt. Er ist ferner mit den Logikeinheiten 10a, 10b gekoppelt.

Durch die Zwischen-Auswertungseinheit 14 kann das Alarmsignal verarbeitet werden, ehe ein zweites Steuersignal erzeugt und an die Logikeinheiten 10a, 10b übertragen wird. Dazu wird eine Bewertung des Alarmsignals erzeugt. Hierunter können unterschiedliche Verarbeitungen des Alarmsignals verstanden werden, wobei die Bewertung insbesondere eine Information darüber umfasst, ob das zweite Steuersignal eine Weiterleitung des Alarmsignals umfassen soll. Das heißt, anhand von Bedingungen, die der Zwischen-Auswertungseinheit 14 vorgegeben sind, kann das zweite Steuersignal anhand des Alarmsignals erzeugt werden und seine Übertragung an die Logikeinheiten 10a, 10b kann gesteuert werden.

Es kann etwa eine Entprellung vorgenommen werden, bei der sichergestellt wird, dass das Alarmsignal zumindest für eine bestimmte minimale Zeitspanne empfangen wird, um als gültig klassifiziert und übertragen zu werden. Auf diese Weise können etwa Fehlfunktionen oder kurzfristige Spannungsspitzen berücksichtigt werden, bei denen gegebenenfalls keine Trennung des Batteriemoduls 1 von dem Spannungsnetz gewünscht ist. Die Bewertung kann hier etwa die Information umfassen, dass das Alarmsignal länger als die vorgegebene Entprellzeit empfangen wurde und das zweite Steuersignal daher das Alarmsignal umfassen soll.

Die Übertragung des Alarmsignals kann ferner durch die Zwischen-Auswertungseinheit 14 verzögert oder unterbrochen werden oder es können bestimmte Bedingungen angewandt werden. Die Zwischen-Auswertungseinheit 14 erlaubt es also, mittels einer Software Einfluss auf die Verarbeitung des Signals zu nehmen, das ohne eine solche zwischengeschaltete Einrichtung direkt übertragen würde. Dadurch ist eine größere Flexibilität des Systems möglich, insbesondere durch eine Anpassung an verschiedene Anwendungsszenarien, etwa zum Testen des Systems ohne eine Belastung der Schaltelemente 6, 7 durch unnötige Schaltvorgänge.

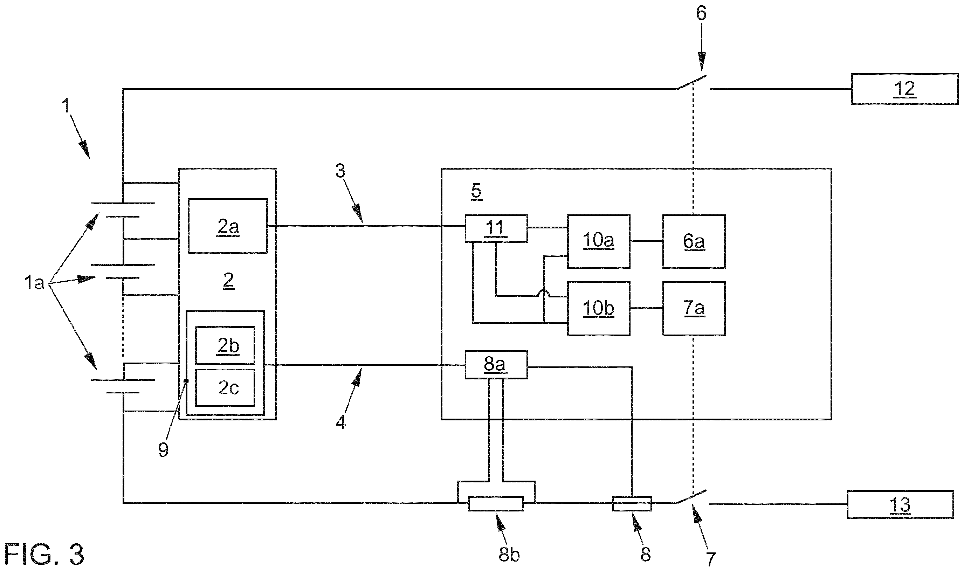

Mit Bezug zu Figur 3 wird ein drittes Ausführungsbeispiel des erfindungsgemäßen Hochspannungs-Batteriesystems erläutert.

Auch das dritte Ausführungsbeispiel basiert auf dem oben mit Bezug zu Figur 1 erläuterten ersten Ausführungsbeispiel. Analog ausgebildete Komponenten des Systems sind daher mit den gleichen Bezugszeichen versehen und werden nachfolgend nicht noch einmal ausführlich erläutert.

Bei dem dritten Ausführungsbeispiel ist vorgesehen, dass das Alarmsignal, wenn es durch das Alarmmodul 9 des CMC 2 erzeugt wird, nicht bei der Erzeugung des Schaltsignals für die Schaltelemente 6, 7 berücksichtigt wird, sondern es dient zur Ansteuerung eines Sicherungselements 8, im vorliegenden Fall einer Pyrosicherung 8. Diese Pyrosicherung 8 wird durch eine Sicherungs-Steuereinheit 8a angesteuert und kann durch diese insbesondere ausgelöst werden. Bei der Auslösung der Pyrosicherung 8 wird ein elektrischer Kontakt mittels Sprengung unterbrochen. Auf diese Weise ist eine besonders zuverlässige und schnelle Trennung des elektrischen Kontakts möglich, auch unter hohen Strömen beziehungsweise Spannungen. Die Trennung ist jedoch nicht reversibel, sodass der elektrische Kontakt erst durch eine Reparatur und einen Austausch der Pyrosicherung 8 und gegebenenfalls weiterer Elemente wieder hergestellt werden kann.

Bei dem dritten Ausführungsbeispiel erzeugt die Sicherungs-Steuereinheit, wenn sie das Alarmsignal empfängt, ein Auslösungssignal 8a zur Auslösung der Pyrosicherung 8. Ferner sieht das dritte Ausführungsbeispiel vor, um fehlerhafte Auslösungen zu vermeiden, dass mittels einer Stromerfassungseinheit 8b, insbesondere durch eine Strommessung mittels eines Shunt 8b, die an dem Batteriemodul 1 anliegende Stromstärke gemessen wird. Anhand dieser Stromstärke, insbesondere durch einen Vergleich mit einem entsprechenden Schwellenwert, kann überprüft werden, ob eine Auslösung der Pyrosicherung 8 tatsächlich notwendig ist. Auch hier kann eine logische Verknüpfung des Alarmsignals und der gemessenen Stromstärke vorgenommen werden, insbesondere mit einem UND- oder ODER-Operator.

Ferner ist bei dem dritten Ausführungsbeispiel vorgesehen, dass der durch die Kommunikationsleitung 3 bereitgestellte Zellspannungsmesswert durch die erste Auswertungseinheit 11 redundant ausgewertet wird. Das erzeugte Steuersignal, welches an die Logikeinheiten 10a, 10b übertragen wird, wird daher redundant mit zwei Ausgaben erzeugt, die anschließend durch die Logikeinheit 10a, 10b verglichen werden.

In weiteren Ausführungsbeispielen kann das Sicherungselement 8 auf eine andere Weise ausgebildet sein, beispielsweise als Schmelzsicherung. Ferner kann das Sicherungselement 8 auch bei den weiteren oben erläuterten Ausführungsbeispielen zusätzlich zu den Schaltelementen 6, 7 vorgesehen sein. Auch die Ansteuerung des Sicherungselements 8 kann auf andere Weise erfolgen, insbesondere unter zusätzlicher Berücksichtigung eines Signals der ersten Auswertungseinheit 11.

### Bezugszeichenliste

- 1: Batteriemodul
- 1a: Batterie
- 2: Batteriemodul-Controller; CMC
- 2a: Erste Erfassungseinheit
- 2b: Zweite Erfassungseinheit
- 2c: Zweite Auswertungseinheit
- 3: Kommunikationsleitung
- 4: Alarmleitung
- 5: Batteriemanagement-Controller; BMC
- 6: Schaltelement; Schütz
- 6a: Ansteuerungseinheit
- 7: Schaltelement; Schütz
- 7a: Ansteuerungseinheit
- 8: Sicherungselement; Pyrosicherung
- 8a: Sicherungs-Steuereinheit
- 8b: Stromerfassungseinheit; Shunt
- 9: Alarmmodul
- 10a: Logikeinheit
- 10b: Logikeinheit
- 11: Erste Auswertungseinheit; Haupt-Mikrocontroller
- 12: Anschluss Traktionsnetz (positiv)
- 13: Anschluss Traktionsnetz (negativ)
- 14: Zwischen-Auswertungseinheit; Sekundär-Mikrocontroller

## Patentansprüche

1. Hochspannungs-Batteriesystem mit
einem Batteriemodul (1) und zumindest zwei Schaltelementen (6; 7), wobei
durch die Schaltelemente (6; 7) eine elektrische Verbindung des Batteriemoduls (1) mit einem Spannungsnetz schaltbar ist;
einer ersten Erfassungseinheit (2a), durch die ein erster Zellspannungsmesswert einer Zellspannung des Batteriemoduls (1) erfassbar ist; und
einer ersten Auswertungseinheit (11), durch die anhand eines Vergleichs des ersten Zellspannungsmesswerts mit einem ersten Schwellenwert ein erstes Steuersignal erzeugbar ist; wobei
anhand des ersten Steuersignals ein Schaltsignal erzeugbar ist; wobei
das Schaltsignal an zumindest eine erste Ansteuerungseinheit (6a) für das erste Schaltelement (6) und an eine zweite Ansteuerungseinheit (7a) für das zweite Schaltelement (7) übertragbar ist;
wobei in Abhängigkeit von dem Schaltsignal das erste (6) und das zweite Schaltelement (7) unabhängig voneinander schaltbar sind; wobei
durch eine zweite Erfassungseinheit (2b) ein zweiter Zellspannungsmesswert einer Zellspannung des Batteriemoduls (1) erfassbar ist; und
durch eine zweite Auswertungseinheit (2c) anhand eines Vergleichs des zweiten Zellspannungsmesswerts mit einem zweiten Schwellenwert ein Alarmsignal erzeugbar ist,
**dadurch gekennzeichnet, dass**
durch eine Sicherungs-Steuereinheit (8a) anhand des Alarmsignals ein Auslösungssignal für ein Sicherungselement (8) erzeugbar ist; wobei
das Sicherungselement (8) in Abhängigkeit von dem Auslösungssignal auslösbar ist; wobei
durch eine Stromerfassungseinheit (8b) ein Strommesswert eines elektrischen Stroms zu dem Batteriemodul (1) erfassbar ist; und
das Auslösungssignal für das Sicherungselement (8) ferner in Abhängigkeit von dem erfassten Strommesswert erzeugbar ist.

2. Hochspannungs-Batteriesystem gemäß Anspruch 1,
**dadurch gekennzeichnet, dass**
das Batteriemodul (1) durch das Spannungsnetz mit einem Traktionsnetz eines Fahrzeugs elektrisch verbunden ist.

3. Hochspannungs-Batteriesystem gemäß einem der Ansprüche 1 und 2,
**dadurch gekennzeichnet, dass**
die Schaltelemente (6; 7) zumindest zwei Schütze (6; 7) umfassen.

4. Hochspannungs-Batteriesystem gemäß einem der Ansprüche 1 bis 3,
**dadurch gekennzeichnet, dass**
das erste Steuersignal und das Alarmsignal an eine Logikeinheit (6a; 7a) übertragbar sind; und
das Schaltsignal durch die Logikeinheit (6a; 7a) erzeugbar ist.

5. Hochspannungs-Batteriesystem gemäß einem der Ansprüche 1 bis 4,
**dadurch gekennzeichnet, dass**
das Alarmsignal an eine Zwischen-Auswertungseinheit (14) übertragbar ist; und
durch die Zwischen-Auswertungseinheit (14) anhand des Alarmsignals ein zweites Steuersignal erzeugbar ist; wobei
das Schaltsignal ferner anhand des zweiten Steuersignals erzeugbar ist.

6. Hochspannungs-Batteriesystem gemäß einem der vorhergehenden Ansprüche, **dadurch gekennzeichnet, dass**
durch die Zwischen-Auswertungseinheit (14) eine Bewertung des Alarmsignals erzeugt wird; und
das zweite Steuersignal anhand der Bewertung erzeugt wird.

7. Verfahren zum Betreiben des Hochspannungs-Batteriesystems gemäß den Ansprüchen 1-6, bei dem
durch eine erste Erfassungseinheit (2a) ein erster Zellspannungsmesswert einer Zellspannung eines Batteriemoduls (1) erfasst wird; und
durch eine erste Auswertungseinheit (11) anhand eines Vergleichs des ersten Zellspannungsmesswerts mit einem ersten Schwellenwert ein erstes Steuersignal erzeugt wird; wobei
anhand des ersten Steuersignals ein Schaltsignal erzeugt wird;
das Schaltsignal an zumindest eine erste Ansteuerungseinheit (6a) für ein erstes Schaltelement (6) und an eine zweite Ansteuerungseinheit (7a) für ein zweites Schaltelement (7) übertragen wird, wobei
durch die Schaltelemente (6; 7) eine elektrische Verbindung des Batteriemoduls (1) mit einem Spannungsnetz schaltbar ist; und
in Abhängigkeit von dem Schaltsignal das erste (6) und das zweite Schaltelement (7) unabhängig voneinander geschaltet werden; wobei
durch eine zweite Erfassungseinheit (2b) ein zweiter Zellspannungsmesswert einer Zellspannung des Batteriemoduls (1) erfasst wird; und
durch eine zweite Auswertungseinheit (2c) anhand eines Vergleichs des zweiten Zellspannungsmesswerts mit einem zweiten Schwellenwert ein Alarmsignal erzeugt wird,
**dadurch gekennzeichnet, dass**
durch eine Sicherungs-Steuereinheit (8a) anhand des Alarmsignals ein Auslösungssignal für ein Sicherungselement (8) erzeugt wird; wobei
das Sicherungselement (8) in Abhängigkeit von dem Auslösungssignal ausgelöst wird, wobei
durch eine Stromerfassungseinheit (8b) ein Strommesswert eines elektrischen Stroms zu dem Batteriemodul (1) erfasst wird; und
das Auslösungssignal für das Sicherungselement (8) ferner in Abhängigkeit von dem erfassten Strommesswert erzeugt wird.

## Claims

1. A high-voltage battery system having
a battery module (1) and at least two switching elements (6; 7), wherein
an electrical connection of the battery module (1) to a voltage network can be switched by the switching elements (6; 7);
a first detection unit (2a), by which a first cell voltage measurement value of a cell voltage of the battery module (1) can be detected; and
a first evaluation unit (11), by means of which a first control signal can be generated on the basis of a comparison of the first cell voltage measurement value with a first threshold value; wherein
a switching signal can be generated on the basis of the first control signal; wherein
the switching signal is transmittable to at least one first actuation unit (6a) for the first switching element (6) and to a second actuation unit (7a) for the second switching element (7);
wherein, depending on the switching signal, the first (6) and the second switching elements (7) can be switched independently of each other: wherein
a second cell voltage measurement value of a cell voltage of the battery module (1) can be detected by a second detection unit (2b); and
an alarm signal can be generated by a second evaluation unit (2c) on the basis of a comparison of the second cell voltage measurement value with a second threshold value,
**characterized in that**
a triggering signal for a fuse element (8) can be generated by a fuse control unit (8a) on the basis of the alarm signal; wherein
the fuse element (8) is triggerable as a function of the triggering signal; wherein
a current measurement value of an electrical current to the battery module (1) can be detected by a current detection unit (8b); and
the triggering signal for the fuse element (8) can also be generated as a function of the detected current measurement value.

2. The high-voltage battery system according to Claim 1,
**characterized in that**
the battery module (1) is electrically connected to a traction network of a vehicle by the voltage network.

3. The high-voltage battery system according to either of Claims 1 and 2,
**characterized in that**
the switching elements (6; 7) comprise at least two contactors (6; 7).

4. The high-voltage battery system according to any one of Claims 1 to 3,
**characterized in that**
the first control signal and the alarm signal are transmittable to a logic unit (6a; 7a); and
the switching signal can be generated by the logic unit (6a; 7a).

5. The high-voltage battery system according to any one of Claims 1 to 4,
**characterized in that**
the alarm signal is transmittable to an intermediate evaluation unit (14); and
a second control signal can be generated by the intermediate evaluation unit (14) on the basis of the alarm signal; wherein
the switching signal can also be generated on the basis of the second control signal.

6. The high-voltage battery system according to any one of the preceding claims, **characterized in that**
an evaluation of the alarm signal is generated by the intermediate evaluation unit (14); and
the second control signal is generated on the basis of the evaluation.

7. A method for operating the high-voltage battery system according to Claims 1 - 6, with which
a first detection unit (2a) detects a first cell voltage measurement value of a cell voltage of a battery module (1); and
a first control signal is generated by a first evaluation unit (11) on the basis of a comparison of the first cell voltage measurement value with a first threshold value; wherein
a switching signal is generated on the basis of the first control signal;
the switching signal is transmitted to at least one first actuation unit (6a) for a first switching element (6) and to a second actuation unit (7a) for a second switching element (7), wherein
an electrical connection of the battery module (1) to a voltage network can be switched by the switching elements (6; 7); and
depending on the switching signal, the first (6) and the second switching elements (7) are switched independently of each other; wherein
a second cell voltage measurement value of a cell voltage of the battery module (1) is detected by a second detection unit (2b); and
an alarm signal is generated by a second evaluation unit (2c) on the basis of a comparison of the second cell voltage measurement value with a second threshold value,
**characterized in that**
a triggering signal for a fuse element (8) is generated by a fuse control unit (8a) on the basis of the alarm signal; wherein
the fuse element (8) is triggered as a function of the triggering signal, wherein
a current measurement value of an electric current to the battery module (1) is detected by a current detection unit (8b); and
the triggering signal for the fuse element (8) is further generated as a function of the detected measured current value.

## Revendications

1. Système de batterie haute tension comprenant
un module de batterie (1) et au moins deux éléments de commutation (6 ; 7), dans lequel
une connexion électrique du module de batterie (1) à un réseau de tension peut être commutée grâce aux éléments de commutation (6 ; 7) ;
une première unité de détection (2a), par laquelle une première lecture de tension d'une cellule d'une tension de cellule du module de batterie (1) peut être détectée ; et
une première unité d'évaluation (11) par laquelle un premier signal de commande peut être généré à partir d'une comparaison de la première lecture de tension de cellule avec une première valeur seuil ; dans lequel
un signal de commutation peut être généré à partir du premier signal de commande ; dans lequel
le signal de commutation peut être transmis à au moins une première unité d'entraînement (6a) pour le premier élément de commutation (6) et à une deuxième unité d'entraînement (7a) pour le deuxième élément de commutation (7) ;
dans lequel le premier (6) et le deuxième élément de commutation (7) sont commutables indépendamment les uns des autres en fonction du signal de commutation ; dans lequel
une deuxième lecture de tension d'une cellule d'une tension de cellule du module de batterie (1) peut être détectée par une deuxième unité de détection (2b) ; et
un signal d'alarme peut être généré par une deuxième unité d'évaluation (2c) à partir d'une comparaison entre la deuxième lecture de tension de cellule avec une deuxième valeur seuil,
**caractérisé en ce que**
un signal de déclenchement pour un élément de fusible (8) peut être généré par une unité de commande de fusible (8a) à l'aide du signal d'alarme ; dans lequel
l'élément de fusible (8) peut être déclenché en fonction du signal de déclenchement ; dans lequel
une lecture de courant d'un courant électrique vers le module de batterie (1) peut être détectée par une unité de détection de courant (8b) ; et
le signal de déclenchement pour l'élément de fusible (8) peut en outre être généré en fonction de la lecture de courant détectée.

2. Système de batterie haute tension selon la revendication 1,
**caractérisé en ce que**
le module de batterie (1) est connecté électriquement par le réseau de tension à un réseau de traction d'un véhicule.

3. Système de batterie haute tension selon l'une quelconque des revendications 1 et 2,
**caractérisé en ce que**
les éléments de commutation (6 ; 7) comprennent au moins deux contacteurs (6 ; 7).

4. Système de batterie haute tension selon l'une quelconque des revendications 1 à 3,
**caractérisé en ce que**
le premier signal de commande et le signal d'alarme peuvent être transmis à une unité logique (6a ; 7a) ; et
le signal de commutation peut être généré par l'unité logique (6a ; 7a).

5. Système de batterie haute tension selon l'une quelconque des revendications 1 à 4,
**caractérisé en ce que**
le signal d'alarme peut être transmis à une unité d'évaluation intermédiaire (14) ; et
un deuxième signal de commande peut être généré par l'unité d'évaluation intermédiaire (14) à partir du signal d'alarme ; dans lequel
le signal de commutation peut en outre être généré à partir du deuxième signal de commande.

6. Système de batterie haute tension selon l'une quelconque des revendications précédentes, **caractérisé en ce que**
une évaluation du signal d'alarme est générée par l'unité d'évaluation intermédiaire (14) ; et
le deuxième signal de commande est généré à partir de l'évaluation.

7. Procédé de fonctionnement du système de batterie haute tension selon les revendications 1 à 6, dans lequel
une première lecture de tension d'une cellule d'une tension de cellule du module de batterie (1) est détectée par une première unité de détection (2a) ; et
un premier signal de commande est généré par une première unité d'évaluation (11) à partir d'une comparaison de la première lecture de tension de cellule avec une première valeur seuil ; dans lequel
un signal de commutation est généré à partir du premier signal de commande ;
le signal de commutation est transmis à au moins une première unité d'entraînement (6a) pour le premier élément de commutation (6) et à une deuxième unité d'entraînement (7a) pour le deuxième élément de commutation (7), dans lequel
une connexion électrique du module de batterie (1) à un réseau de tension peut être commutée grâce aux éléments de commutation (6 ; 7) ; et
le premier (6) et le deuxième élément de commutation (7) sont commutés indépendamment les uns des autres en fonction du signal de commutation ; dans lequel
une deuxième lecture de tension d'une cellule d'une tension de cellule du module de batterie (1) est détectée par une deuxième unité de détection (2b) ; et
un signal d'alarme est généré par une deuxième unité d'évaluation (2c) à partir d'une comparaison entre la deuxième lecture de tension de cellule avec une deuxième valeur seuil,
**caractérisé en ce que**
un signal de déclenchement pour un élément de fusible (8) est généré par une unité de commande de fusible (8a) à l'aide du signal d'alarme ; dans lequel
l'élément de fusible (8) est déclenché en fonction du signal de déclenchement, dans lequel
une lecture de courant d'un courant électrique vers le module de batterie (1) est détectée par une unité de détection de courant (8b) ; et
le signal de déclenchement pour l'élément de fusible (8) est en outre généré en fonction de la lecture de courant détectée.
